# EUROPÄISCHE PATENTSCHRIFT

(11) **EP 0 691 655 B1**
(45) Veröffentlichungstag und Bekanntmachung des Hinweises auf die Patenterteilung: **25.08.1999**
(21) Anmeldenummer: 95110178.1
(22) Anmeldetag: 29.06.1995
(51) Int. Cl.: G11C 5/00, H01L 25/10

(54) **Modulkarte**
Module card
Carte de module

(30) Priorität: 05.07.1994 DE 4423567
(43) Veröffentlichungstag der Anmeldung: 10.01.1996
(73) Patentinhaber: SIEMENS AKTIENGESELLSCHAFT, 80333 München (DE)
(72) Erfinder: Michael, Ewald, Dipl.-Phys., D-85540 Haar (DE)

(56) Entgegenhaltungen:
- DE-A- 3 428 346
- DE-A- 4 032 370
- DE-A- 4 207 226
- PATENT ABSTRACTS OF JAPAN vol. 7 no. 286 (P-244) [1431] ,21.Dezember 1983 & JP-A-58 159280 (FUJITSU)
- PATENT ABSTRACTS OF JAPAN vol. 5 no. 125 (E-69) [797] ,12.August 1981 & JP-A-56 061154 (SHARP)
- PATENT ABSTRACTS OF JAPAN, Band 18, Nr. 171 (E-1529) , 23-03-1994 & JP 05-343579 A

## Beschreibung

Die Erfindung betrifft eine Modulkarte für z. B. Speicherbausteine für Computersysteme nach dem Oberbegriff des Patentanspruchs 1.

Eine derartige Modulkarte ist z. B. aus der US-A-4,656,605 bekannt.

Speicherbausteine werden in Computersysteme immer weniger als Einzelbausteine eingesetzt, sondern unter Verwendung von Speichermodulkarten, d. h. einer Kombination von Speicherbausteinen, die bereits auf einer löt- bzw. steckbaren standardisierten Platine montiert sind. Ein Beispiel ist die SIMM-Karte (Single In-Line Memory Module),die in der JEDEC-Norm angegeben ist. Figur 1 zeigt eine derartige Standard-DRAM-Modulkarte 1, wie in US-A-4,655,605 beschrieben ist. Mindestens eine erste integrierte Schaltung 2, hier in Form von DRAM-Speicherbausteinen, sind an Anschlußstellen 7 auf der Modulkarte 1 montiert. Auf einer Seite der Modulkarte sind externe Anschlüsse 3 als Systemschnittschnelle, beispielsweise zu einem Computersystem. Die Systemschnittstelle kann z. B. ein Systembus sein. Die Modulkarte 1 ist normalerweise in Form einer löt- bzw. steckbaren Platine ausgeformt, die einfach auswechselbar ist.

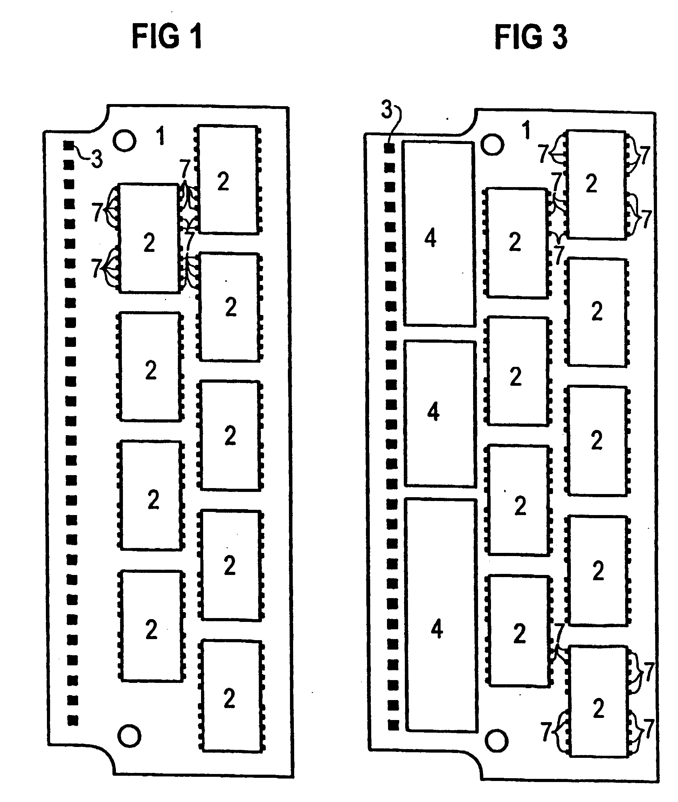

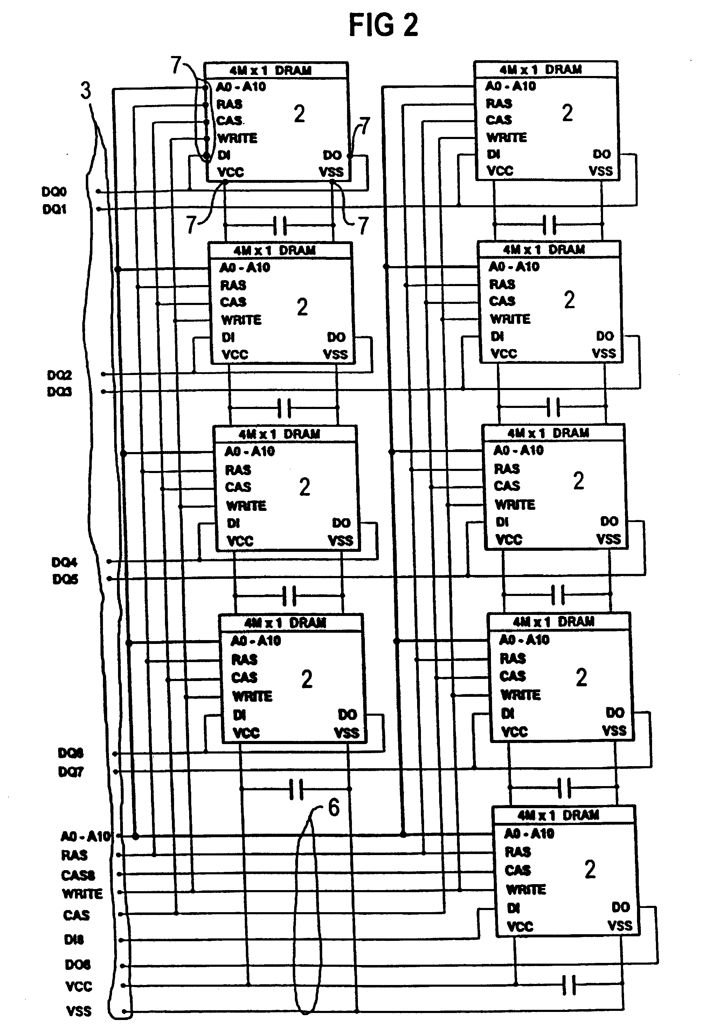

Figur 2 zeigt ein mögliches Blockschaltbild der Modulkarte nach Figur 1. Wie hier deutlich angegeben ist, enthalt die Modulkarte 1 lediglich Leiterbahnen 6 zwischen den ersten integrierten Schaltungen 2 und den externen Anschlüssen 3.

Diese Module lassen sich einfach in den unterschiedlichsten Systemen als Speichermedien einsetzen. Dabei gibt es jedoch häufig Schnittstellenprobleme: Zum Beispiel ob der Systembus in TTL- oder ECL-Technologie abgebaut ist, welche Busleitungen elektrisch abgeschlossen sind usw.. Diese unterschiedlichen Schnittstellenkonfigurationen erfordern den Einsatz aufwendiger Zusatzschaltungen wie Treiberbausteine und Fehlerkorrekturschaltungen im Computersystem. Aus Kosten- und Standardisierungsgründen ist es im allgemeinen nicht möglich, alle vorhandenen Schnittstellen bereits in den Einzelbausteinen vorzusehen.

Im Stand der Technik sind auch sogenannte "intelligente" Speicher-Modulkarten bekannt, wo die zum Speicher notwendige Zusatzlogik in weiteren integrierten Schaltungen auf die Modulkarte implementiert ist. Die weiteren integrierten Schaltungen kommunizieren mit dem Systembus und kontrollieren den Fluß von Daten, die eingeschrieben bzw. ausgelesen werden.

Diese sogenannten "intelligente" Modulkarten können daher in einer Vielfalt von Systemkonfigurationen eingesetzt werden, da die Zusatzlogik einfach nach den vorhandenen Systemerfordernissen durch Programmierung der Zusatzlogik modifizierbar ist. Diese Lösung zeigt sich aber als kostspielig beim Einsatz einfacherer Systeme, wo die aufwendige Zusatzlogik nicht immer unbedingt notwendig sind, und wo die Zugriffsgeschwindigkeit des Speichers nicht so kritisch wie bei den Großrechnern ist.

In PATENT ABSTRACTS OF JAPAN, vol. 18, no. 171 (E-1529), 23.03.1994, betreffend die JP 05-343 579 A, ist eine Modulkarte mit trennbaren Leiterbahnen gemäß der im Oberbegriff des Patenanspruchs 1 angegebenen Art beschrieben.

Aufgabe der vorliegenden Erfindung ist, eine Modulkarte zu konzipieren, die die Flexibilität zum Einsatz unterschiedlicher Systeme hat und gleichzeitig eine kostengünstige Lösung anbietet.

Diese Aufgabe wird durch die Merkmale des kennzeichnenden Teils des Patentanspruchs 1 gelost. Bevorzugte Weiterbildungen sind Kennzeichen von Unteransprüchen.

Die Erfindung wird nachfolgend anhand von 7 Figuren näher erläutert. Es zeigen:
- Figur 1: eine Modulkarte gemäß dem Stand der Technik.
- Figur 2: ein Blockschaltbild der Modulkarte nach Figur 1,
- Figur 3: eine Modulkarte gemäß der vorliegenden Erfindung,
- Figuren 4-6: Blockschaltbilder unterschiedlicher Verdrahtungsmöglichkeiten der Modulkarte nach Figur 3,
- Figur 7: eine weitere Modulkarte gemäß der vorliegenden Erfindung.

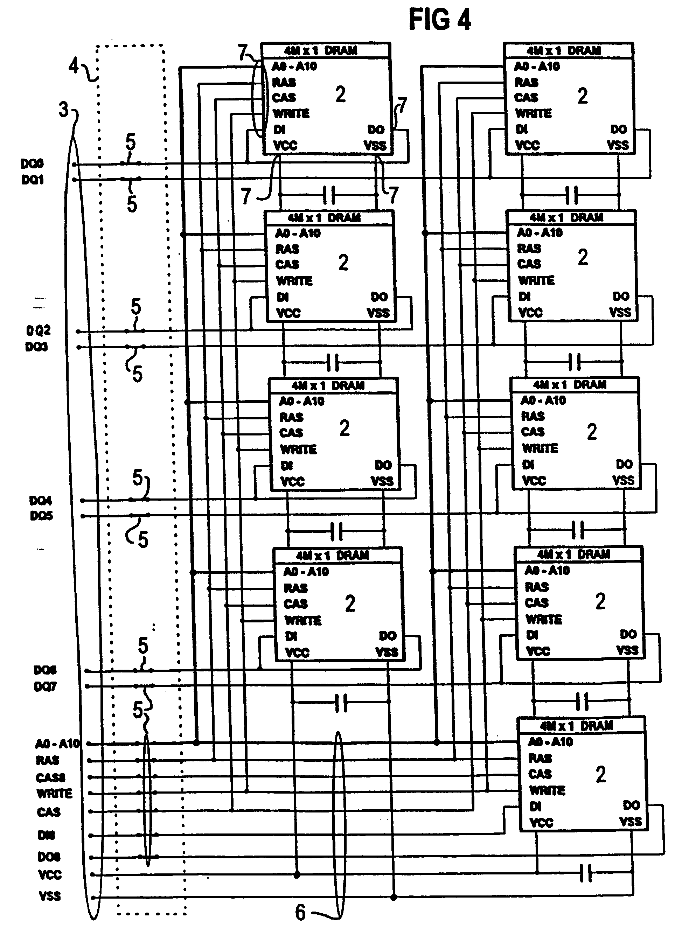

Figur 3 zeigt eine Modulkarte 1 gemäß der vorliegenden Erfindung, und die Figuren 4-6 zeigen Blockschaltbilder unterschiedlicher Verdrahtungsmöglichkeiten der Modulkarte nach Figur 3. Im Unterschied zu der in Figur 1 gezeigten Modulkarte sind die Leiterbahnen 6 für die externen Anschlüsse 3 so ausgeführt, daß sie wahlweise mittels trennbarer Verbindungselemente 5 (siehe Figur 4) mit den ersten integrierten Schaltungen 2 verbindbar sind, oder daß sie über mindestens eine weitere integrierte Schaltung 4 mit den ersten integrierten Schaltungen 2 verbunden ist. Diese weiteren integrierten Schaltungen 4 können zum Beispiel Treiberschaltungen und/oder Zusatzlogik wie Fehlererkennung/-Korrekturschaltungen, CACHE-Speicher, Refresh-Schaltungen usw. sein.

Figur 4 zeigt ein mögliches Blockschaltbild der Modulkarte nach Figur 3, bei der die externen Anschlüsse 3 durch trennbare Verbindungselemente 5 direkt mit den ersten integrierten Schaltungen 2 verbunden sind.

Eine weitere integrierte Schaltung 4, in Figur 4 gestrichelt gezeichnet, ist in diesem Fall nicht vorgesehen. Sie ist daher nicht auf der Modulkarte 1 angeordnet.

Mittels der trennbaren Verbindungselemente 5 ist es möglich, die Modulkarte nach der vorliegenden Erfindung ohne zusätzliche Bausteine zur Schnittstellenanpassung zu benutzen. Wenn aber Treiber- und/oder Zusatzlogikschaltungen erforderlich sind, können diese einfach nach Bedarf auf die bereits vorgesehenen Anschlüsse montiert werden.

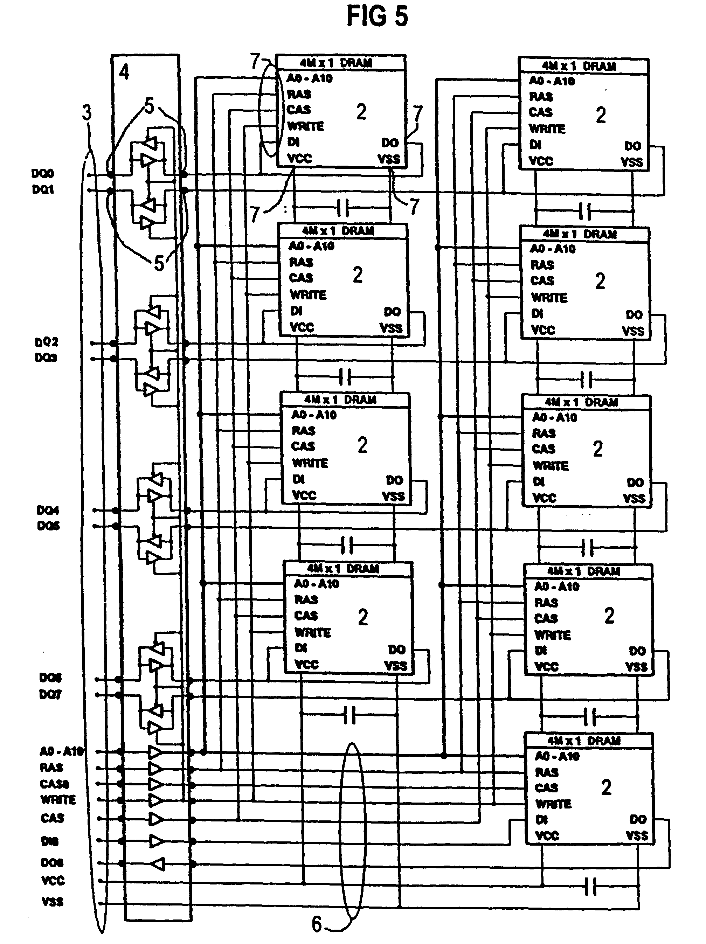

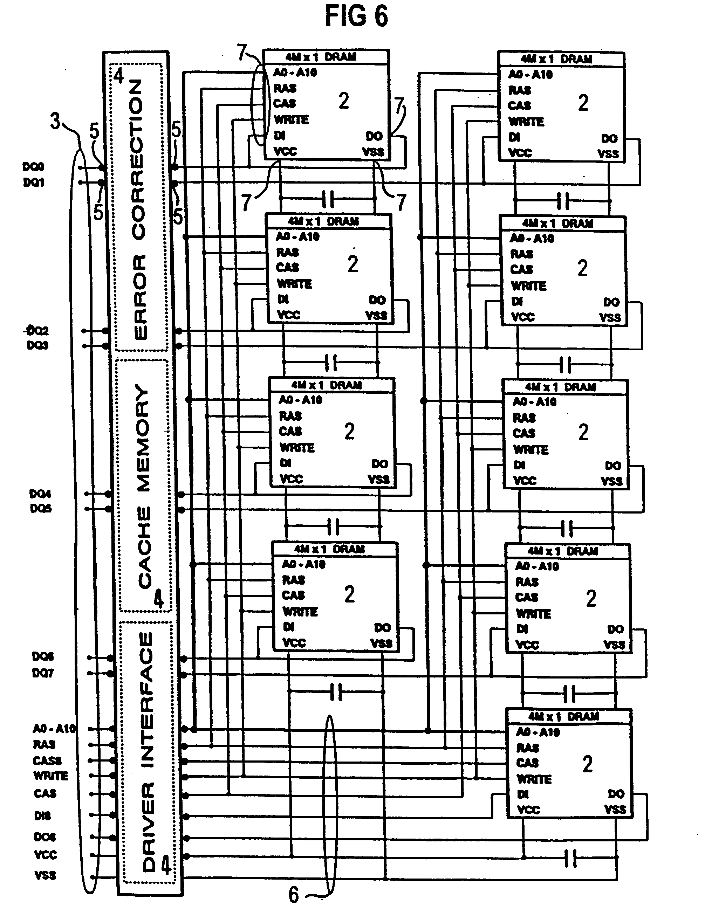

Figur 5 zeigt ein Blockschaltbild der Modulkarte nach Figur 3, wo die trennbaren Verbindungselemente 5 unterbrochen sind, und eine weitere integrierte Schaltung 4 (oder mehrere) zwischen den externen Anschlüssen 3 und den ersten integrierten Schaltungen 2, hier als Speicherbausteine, geschaltet ist. Die weiteren integrierten Schaltungen 4 sind hier als Treiberbausteine dargestellt, die nach den Systembus-Erfordernissen angepaßt sind. Das Blockschaltbild nach Figur 6 zeigt, daß auch die Implementierung aufwendiger Logik (Fehlererkennung/-Korrektur, CACHE-Speicher, automatisch Refresh usw.) neben Treiberschaltungen in den weiteren integrierten Schaltungen 4 möglich ist. Die vorliegende Erfindung ermöglicht daher, daß die Modulkarte bei Bedarf von der Ausführung als Standard-Modulkarte (d. h. ohne die weitere integrierte Schaltung 4) in eine "intelligente" Modulkarte mit minimalem Zusatzaufwand modifizierbar ist.

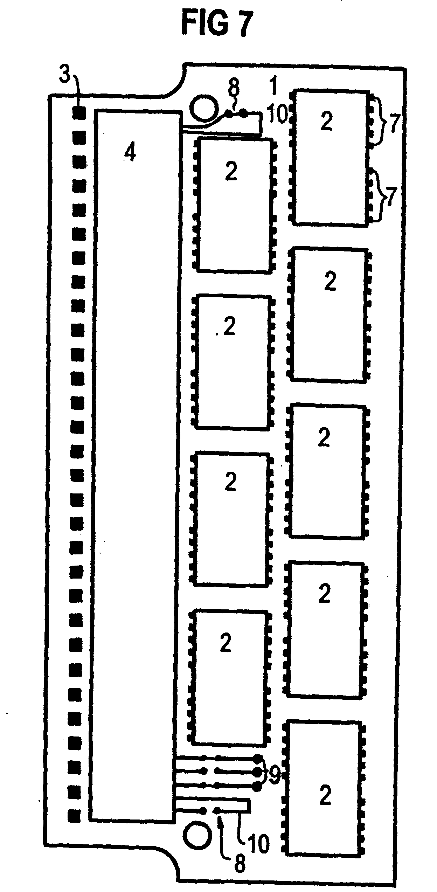

Die Modulkarte nach Figur 7 weist auch zusätzliche trennbare Verbindungselemente 8 auf, um die weitere integrierte Schaltung 4 für verschiedene Anforderungen, wie elektrischer Busabschluß, TTL/ECL-Technologien usw. programmieren zu können. Diese Anforderungen des Systems können auch durch Signale aus dem Systembus zur Modulkarte geleitet werden, um z. B. die Treiberschaltungen entsprechend anzupassen.

Die zusätzlichen trennbaren Verbindungselemente 8 können die weitere integrierte Schaltung 4 mit z. B. Masse, der Versorgungsspannung oder an der Modulkarte vorhandenen Signalen verbinden, was hier durch die Kontaktpunkte 9 zu den Leiterbahnen 6 der Modulkarte geschieht. Die zusätzlichen trennbaren Verbindungselemente 8 können auch zwei Anschlüsse der weiteren integrierten Schaltung 4 durch die Leiterbahnen 10 miteinander verbinden. Dadurch kann ein innerhalb der weiteren integrierten Schaltung vorhandenes Signal beeinflußt werden. Durch Trennung einer der zusätzlichen trennbaren Verbindungselemente 8 können daher interne Signale und Spannungen der weiteren integrierten Schaltung 4 beeinflußt werden, um die weitere integrierte Schaltung programmieren zu können.

In Figur 7 ist eine weitere integrierte Schaltung 4 dargestellt. Es ist auch - wie in Figur 3 - Platz für mehrere integrierte Schaltungen vorsehbar.

Obwohl die obengenannten Beispiele der Erfindung sich auf Speicher-Modulkarte beziehen, ist es dem Fachmann offensichtlich, daß die erfindungsgemäßen Modulkarten auch für andere Speicherkarten als SIMM-Module und für andere Arten von Halbleiterbausteinen verwendbar sind.

## Patentansprüche

1. Modulkarte (1) in Form einer Platine mit Leiterbahnen (6), ersten Anschlußstellen (7) für mindestens eine erste integrierte Schaltung (2), externen Anschlüssen (3) für Eingabe/Ausgabe-Signale, bei der die Leiterbahnen (6) trennbare Verbindungselemente (5) zur Verbindung zwischen den externen Anschlüssen (3) und den ersten Anschlußstellen (7) aufweisen,
**dadurch gekennzeichnet**,
daß zwischen den externen Anschlüssen (3) und den ersten Anschlußstellen (7) eine weitere integrierte Schaltung (4) angeordnet ist, die in Abhängigkeit vom Zustand der trennbaren Verbindungselemente (5) die zwischen den ersten Anschlußstellen (7) und den externen Anschlüssen (3) verlaufenden Eingabe-/Ausgabe-Signale unterschiedlich beeinflußt.

2. Modulkarte nach Anspruch 1,
**dadurch gekennzeichnet**,
daß bei ungetrennten Verbindungselementen (5) die externen Anschlüsse (3) direkt mit den ersten Anschlußstellen verbunden sind.

3. Modulkarte nach Anspruch 1,
**dadurch gekennzeichnet**,
daß die mindestens eine weitere integrierte Schaltung (4) eine Busabschlußschaltung mit Fehlerkorrekturfunktion beeinhaltet.

4. Modulkarte nach einem der Ansprüche 1 bis 2,
**dadurch gekennzeichnet**,
daß die mindestens eine integrierte Schaltung (2) ein integrierter Halbleiterspeicher ist.

5. Modulkarte nach einem der Ansprüche 1 bis 4,
**dadurch gekennzeichnet**,
daß die mindestens eine integrierte Schaltung (2) ein DRAM-Speicher ist.

6. Modulkarte nach einem der Ansprüche 1 bis 5,
**dadurch gekennzeichnet**,
daß die mindestens eine weitere integrierte Schaltung (4) eine Treiberschaltung beinhaltet.

7. Modulkarte nach einem der Ansprüche 1 bis 6,
**dadurch gekennzeichnet**,
daß die Modulkarte weitere trennbare Verbindungselemente (8) aufweist, die einer Modifizierung der Funktion der mindestens einen weiteren integrierten Schaltung (4) dienen.

8. Modulkarte nach Anspruch 7,
**dadurch gekennzeichnet**,
daß mindestens eines der weiteren Verbindungselemente (8) mindestens eine der weiteren integrierten Schaltungen (4) mit auf den Leiterbahnen (6) vorhandenen Bezugspotentialen der Signale verbindbar ist.

9. Modulkarte nach Anspruch 7,
**dadurch gekennzeichnet**,
daß mindestens eines der weiteren Verbindungselemente (8) einer möglichen Verbindung (10) zwischen zwei Anschlüssen der mindestens einen weiteren integrierten Schaltung (4) dient.

## Claims

1. Module board (1) in the form of a board having conductor tracks (6), first connection points (7) for at least one first integrated circuit (2), external connections (3) for input/output signals, in the case of which the conductor tracks (6) have separable connecting elements (5) for connection between the external connections (3) and the first connection point (7), characterized in that a further integrated circuit (4) is arranged between the external connections (3) and the first connection points (7) and has a different influence on the input/output signals running between the first connection points (7) and the external connections (3), depending on the state of the separable connecting elements (5).

2. Module board according to Claim 1, characterized in that, when the connecting elements (5) are not separated, the external connections (3) are connected directly to the first connection points.

3. Module board according to Claim 1, characterized in that the at least one further integrated circuit (4) contains a bus termination circuit having an error correction function.

4. Module board according to one of Claims 1 or 2, chatacterized in that the at least one integrated circuit (2) is an integrated semiconductor memory.

5. Module board according to one of Claims 1 to 4, characterized in that the at least one integrated circuit (2) is a DRAM memory.

6. Module board according to one of Claims 1 to 5, characterized in that the at least one further integrated circuit (4) contains a driver circuit.

7. Module board according to one of Claims 1 to 6, characterized in that the module board has further separable connecting elements (8), which are used to modify the function of the at least one further integrated circuit (4).

8. Module board according to Claim 7, characterized in that at least one of the further connecting elements (8) at least one of the further integrated circuits (4) can be connected to signal reference-earth potentials which are present on the conductor tracks (6).

9. Module board according to Claim 7, characterized in that at least one of the further connecting elements (8) is used for a possible connection (10) between two connections of the at least one further integrated circuit (4).

## Revendications

1. Carte (1) de module en forme d'une platine, comportant des pistes (6) conductrices, des premiers points (7) de raccordement pour au moins un premier circuit (2) intégré, des bornes (3) extérieures pour des signaux d'entrée/sortie, dans laquelle les pistes (6) conductrices comportent des éléments (5) de liaison séparables pour la liaison entre les bornes (3) extérieures et les premiers points (7) de raccordement, caractérisée en ce qu'il est monté entre les bornes (3) extérieures et les premiers points (7) de raccordement un circuit (4) intégré supplémentaire, qui, en fonction de l'état des éléments (5) de liaison séparables, influence différemment les signaux d'entrée/sortie passant entre les premiers points (7) de raccordement et les bornes (3) extérieures.

2. Carte de module suivant la revendication 1, caractérisée en ce que, lorsque les éléments (5) de liaison ne sont pas séparés, les bornes (3) extérieures sont reliés directement aux premiers points de raccordement.

3. Carte de module suivant la revendication 1, caractérisée en ce que le au moins un circuit intégré supplémentaire contient un circuit de terminaison de bus à fonction de correction d'erreur.

4. Carte de module suivant l'une des revendications 1 à 2, caractérisée en ce que le au moins un circuit (2) intégré est une mémoire intégrée à semi-conducteur.

5. Carte de module suivant l'une des revendications 1 à 4, caractérisée en ce que le au moins un circuit (2) intégré est une mémoire DRAM.

6. Carte de module suivant l'une des revendications 1 à 5, caractérisée en ce que le au moins un circuit (4) intégré supplémentaire contient un circuit d'attaque.

7. Carte de module suivant l'une des revendications 1 à 6, caractérisée en ce que la carte de module comporte des éléments (8) de liaison séparables supplémentaires, qui servent à une modification de la fonction du au moins un circuit (4) intégré supplémentaire.

8. Carte de module suivant la revendication 7, caractérisée en ce qu'au moins l'un des éléments (8) de liaison supplémentaires relie au moins l'un des circuits (4) intégré supplémentaire à des potentiels de référence des signaux présents sur les pistes (6) conductrices.

9. Carte de module suivant la revendication 7, caractérisée en ce qu'au moins l'un des éléments (8) de liaison supplémentaires sert à une liaison (10) possible entre deux bornes du au moins un circuit (4) intégré supplémentaire.
